# EUROPEAN PATENT APPLICATION

(11) **EP 4 517 755 A1**
(43) Date of publication of application: **05.03.2025**
(21) Application number: 24183954.7
(22) Date of filing: 24.06.2024
(51) Int. Cl.: G11C 11/412, G11C 11/419, G11C 5/00

(54) **ASYMMETRICAL MEMORY CIRCUITS AND METHODS**

(30) Priority: 31.08.2023 US 202318241217
(71) Applicant: INTEL Corporation, Santa Clara, CA 95054 (US)
(72) Inventor: LEE, Andy, Sunnyvale, CA 94087 (US); HIGGINS, James, Santa Clara, CA 95054 (US); PARKHOUSE, David, Hillsboro, OR 97124 (US); CHEN, Shuxian, Santa Clara, CA 95054 (US); CUI, Yan, Milpitas, CA 95035 (US); SINHA, Shankar, San Jose, CA 95125 (US)
(74) Representative: Viering, Jentschura & Partner mbB Patent- und Rechtsanwälte

(57) **Abstract**

A memory circuit includes first and second inverters that are cross coupled. The first inverter is configured to provide a first drive current from a first supply line to store a first logic state in the memory circuit. The first drive current is larger than a second drive current that the second inverter is configured to provide from the first supply line to store a second logic state in the memory circuit.

## Description

### TECHNICAL FIELD

The present disclosure relates to asymmetrical memory circuits, systems, and methods that have improved resistance to soft errors.

### BACKGROUND ART

Many types of integrated circuits (ICs) have memory circuits that include arrays of memory cells. Each of the memory cells stores one or more digital bits. The memory cells in a memory array are typically arranged in rows and columns. The memory cells may be, for example, random access memory (RAM), such as static RAM (SRAM) or dynamic RAM (DRAM).

### BRIEF DESCRIPTION OF DRAWINGS

Figure 1A is a diagram that shows a schematic representation of an asymmetrical memory circuit having two p-channel transistors in one cross coupled inverter.
Figure 1B is a diagram that shows a schematic representation of an asymmetrical memory circuit having a larger size p-channel transistor in one cross coupled inverter.
Figure 2 is diagram that shows a schematic representation of an asymmetrical memory circuit having a tristate p-channel transistor that turns off supply current to another p-channel transistor in an inverter during a write operation.
Figure 3A is a diagram that shows a schematic representation of an asymmetrical memory circuit having an additional p-channel transistor in one cross coupled inverter and an additional n-channel transistor in another cross coupled inverter.
Figure 3B is a diagram that shows a schematic representation of an asymmetrical memory circuit having an additional n-channel transistor in a cross coupled inverter.
Figure 4 is a diagram of an illustrative example of a configurable integrated circuit (IC).

### DETAILED DESCRIPTION

A configuration random access memory (CRAM) circuit is a distributed memory circuit that stores configuration data for configuring the functions of a configurable logic integrated circuit (IC), such as a field programmable gate array (FPGA). Any corruption of the data stored in the CRAM can cause a logic error of the configurable logic IC. Such data corruption can occur when energetic particles interact with the CRAM circuits, causing one or more stored values to erroneously change. This phenomenon is otherwise known as a soft error and the rate with which these soft errors occur is referred to as the soft error rate (SER).

Data corruption caused by soft errors is a problem in all memory circuits. The soft error rate of a memory circuit can be improved by increasing the drive current of the bit cell transistors by increasing the physical size of the bit cell transistors. However, because data stored in memory circuits is usually random, transistor sizing is symmetrical. Increasing the size of the bit cell transistors has the negative effect of increasing static power consumption, increasing bit cell area, as well as decreasing the functional write margin of the memory cell.

Most of the CRAM circuits in an FPGA control large fan-in multiplexer circuits. These CRAM circuits are typically one-hot implementations that directly drive a corresponding routing pass gate. Consequently, only a small percentage of CRAM circuits in an FPGA store a logic one (i.e., a logic high state), while most of the CRAM circuits in an FPGA store a logic zero (i.e., a logic low state). Additionally, in FPGAs, a large percentage of silicon hardware is not used within a given user design. For this unused logic circuitry, the associated CRAM circuits are typically assigned a default logic polarity, such that a logic low state is used. Therefore, the logic low preferred state of the CRAM circuits can be used to improve SER by asymmetrically sizing the bit cell transistors. With the asymmetric sizing, SER is improved at a minimum expense of power consumption and memory cell area.

A 6-transistor static RAM (SRAM) memory circuit is often used in cache memories and in the CRAM circuits of FPGAs. As mentioned above, the sizes of the transistors in a memory circuit influence the SER of the memory circuit. Generally, because random data is often stored in a RAM circuit, the n-channel and p-channel transistor pairs are sized symmetrically. However, most CRAM circuits in an FPGA store a logic low state at the bit line and a logic high state at the inverted bit line, because of the high usage of large fan-in multiplexer circuits and because of the high percentage of unused resources. Because of the logic states of most of the CRAM circuits, the SER of the CRAM circuits can be significantly improved by increasing the size of only one side of the cross-coupled inverters within the CRAM circuit.

According to some implementations disclosed herein, a memory circuit is provided that includes a pair of cross coupled inverters and two pass transistors. One of the pass transistors is coupled to a bit line and an address line, and the other pass transistor is coupled to an inverted bit line and the address line. One of the cross coupled inverters has one or more transistors that have a larger drive current from a supply line than the one or more transistors in the other cross coupled inverter that draw current from the same supply line. Increasing the drive current of the transistor(s) in one of the cross coupled inverters in a memory circuit compared to the transistor(s) in the other cross coupled inverter in the memory circuit can help maintain the logic states stored in the memory circuit in the event of an energetic particle strike.

As an example, the p-channel transistors in a first one of the cross coupled inverters can have a larger drive current compared to the p-channel transistor in the second one of the cross coupled inverters, by coupling two p-channel transistors in parallel in the first one of the cross coupled inverters. As another example, the p-channel transistor in the first one of the cross coupled inverters can have a larger drive current compared to the p-channel transistor in the second one of the cross coupled inverters, by increasing the channel width-to-length (W/L) ratio of the p-channel transistor in the first one of the cross coupled inverters compared to the channel W/L ratio of the p-channel transistor in the second one of the cross coupled inverters.

Furthermore, soft errors tend to occur more often at nodes with lower capacitance values. For many FPGA CRAM circuits, only the CRAM storage node coupled to the bit line drives external logic circuits, while the CRAM storage node coupled to the inverted bit line does not drive external logic circuits. As a result, the inverted bit line has a lower capacitance than the bit line and is more likely to experience an undesired SER-induced polarity flip. Increasing the drive current provided by the p-channel transistor(s) coupled to the inverted bit line in a CRAM circuit adds additional capacitance to the inverted bit line, enabling improved SER on the CRAM node that is most vulnerable to a soft error, while also providing the increased drive current strength to hold the node at the desired polarity.

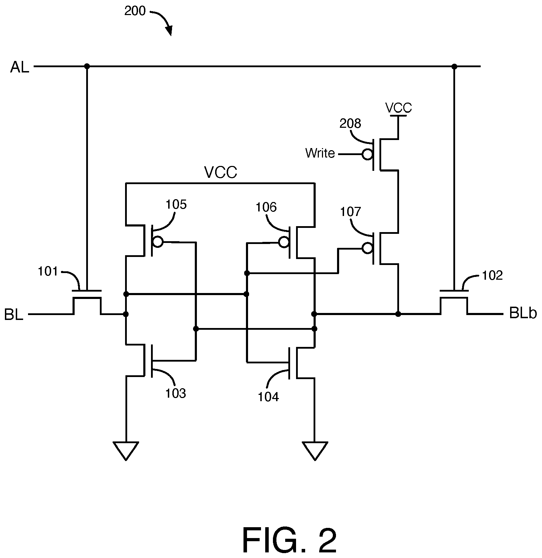

Increasing the drive current provided by the transistor(s) in one of the cross coupled inverters in a memory circuit may require extra die area in an integrated circuit. Although some process nodes for semiconductors may opportunistically be able to add an additional p-channel transistor without growing the size of the memory circuit. Thus, adding one p-channel transistor to a 6-transistor FPGA CRAM circuit can significantly improve the SER failure, without costing additional die area and with only a very small increase in static power consumption. However, the extra p-channel transistor may decrease the write margin for writing a logic low state to the inverted bit line storage node. This issue can be mitigated using a variety of different techniques as disclosed herein, for example, with respect to Figures 2-3.

One or more specific examples are described below. In an effort to provide a concise description of these examples, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Throughout the specification, and in the claims, the term "connected" means a direct electrical connection between the circuits that are connected, without any intermediary devices. The term "coupled" means either a direct electrical connection between circuits or an indirect electrical connection through one or more passive or active intermediary devices that allows the transfer of information between circuits. The term "circuit" may mean one or more passive and/or active electrical components that are arranged to cooperate with one another to provide a desired function.

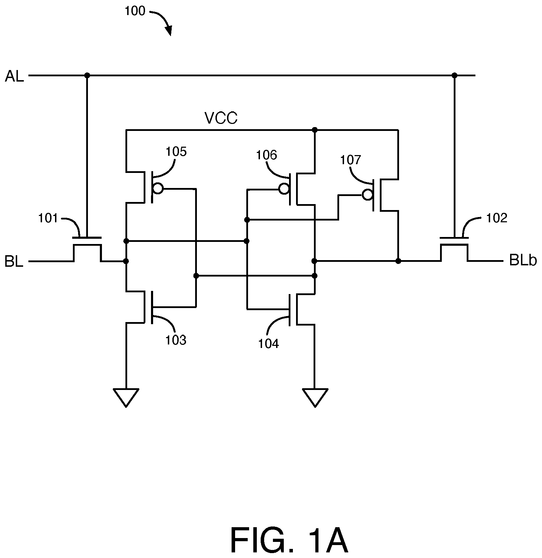

Figure 1A is a diagram that shows a schematic representation of an asymmetrical memory circuit 100 having an additional p-channel transistor in one cross coupled inverter. Memory circuit 100 of Figure (FIG.) 1A includes 4 n-channel field-effect transistors (FETs) 101-104 and 3 p-channel field-effect transistors (FETs) 105-107. The FETs disclosed herein may be, for example, metal oxide semiconductor FETs (i.e., MOSFETs). Memory circuit 100 includes two cross coupled inverters and two pass transistors 101-102. The cross coupled inverters are coupled between a supply voltage VCC and a ground voltage (shown as triangles in the Figures). The supply voltage VCC is provided to the cross coupled inverters through a first supply line, and the ground voltage is provided to the cross coupled inverters through a second supply line. The first cross coupled inverter includes p-channel transistor 105 and n-channel transistor 103. The second cross coupled inverter includes p-channel transistors 106-107 and n-channel transistor 104. Because the second cross coupled inverter includes two p-channel transistors 106-107, and the first cross coupled inverter only includes one p-channel transistor 105, the memory circuit 100 is asymmetrical. Each of the p-channel transistors 105-107 can have the same size (e.g., the same channel width-to-length (W/L) ratio), and each of the n-channel transistors 103 and 104 can have the same size.

The gates of transistors 103 and 105 are coupled to the drains of transistors 104 and 106-107 and to the first drain/source of transistor 102. The second drain/source of transistor 102 is coupled to an inverted bit line BLb. The gate of transistor 102 is coupled to an address line AL (also referred to as a word line). The gates of transistors 104 and 106-107 are coupled to the drains of transistors 103 and 105 and to the first drain/source of transistor 101. The second drain/source of transistor 101 is coupled to a bit line BL. The gate of transistor 101 is coupled to the address line AL. Memory circuit 100, and other memory circuits disclosed herein, can be provided in any type of integrated circuit die, such as for example, a configurable logic IC (e.g., an FPGA), a microprocessor IC, a graphics processing unit (GPU) IC, a memory IC, etc.

In most CRAM circuits in FPGAs (e.g., about 85% of CRAM circuits), a logic low state is most often stored at the drains of transistors 103 and 105 (i.e., a logic high state stored at the drains of transistors 104 and 106), p-channel transistor 105 is configured in the off state, and p-channel transistor 106 is configured in the on state. Therefore, adding an additional p-channel transistor to the first cross coupled inverter (e.g., in parallel with transistor 105) causes very low improvement to overall CRAM circuit SER failures.

As shown in FIG. 1A, memory circuit 100 includes an additional p-channel transistor 107 that is coupled in parallel with p-channel transistor 106 in the second cross coupled inverter. The additional p-channel transistor 107 causes the second cross coupled inverter to provide additional drive current when transistors 106-107 are on to store a first logic state in the memory circuit 100 compared to the drive current provided by the single p-channel transistor 105 in the first cross coupled inverter when transistor 105 is on to store a second logic state in the memory circuit 100. Increasing the drive current of the p-channel transistors 106-107 in the second cross coupled inverter compared to the p-channel transistor 105 in the first cross coupled inverter can help maintain the logic states stored in the memory circuit 100 in the event of an energetic particle strike (i.e., when a logic high state is stored at the drains of transistors 104 and 106-107). The asymmetrical increase in the combined sizing and drive current of p-channel transistors 106-107 compared to transistor 105 provides a significant improvement in overall single-event upset (SEU) rate without the need to increase the size of transistor 105. According to other embodiments, memory circuit 100 can include a third p-channel transistor (and also optionally fourth, fifth, etc. p-channel transistors) coupled in parallel with transistors 106-107 to provide additional drive current and a further reduced SEU rate.

In order to store a logic high state in memory circuit 100 at the drains of transistors 103 and 105, the voltage at AL is driven to a logic high state to turn on pass transistors 101-102, the voltage at bit line node BL is driven to a logic high state, and the voltage at the inverted bit line BLb is driven to a logic low state. In response to logic high states on lines AL and BL and a logic low state on inverted bit line BLb, memory circuit 100 stores a logic high state at the drains of transistors 103 and 105 and a logic low state at the drains of transistors 104 and 106-107. The addition of transistor 107 to memory circuit 100 may decrease the write margin for writing a logic high state into memory circuit 100 at the drains of transistors 103 and 105, because transistors 106 and 107 have an increased combined drive current relative to the drive current of transistor 102.

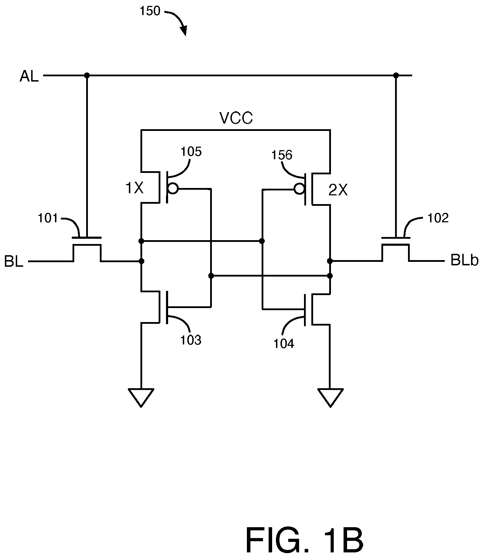

Figure 1B is a diagram that shows a schematic representation of an asymmetrical memory circuit 150 having a larger size p-channel transistor in one cross coupled inverter. Memory circuit 150 of FIG. 1B includes 4 n-channel field-effect transistors (FETs) 101-104 and 2 p-channel field-effect transistors (FETs) 105 and 156. Memory circuit 100 includes two pass transistors 101-102 and two cross coupled inverters coupled between a supply voltage VCC at a first supply line and a ground voltage at a second supply line. The first cross coupled inverter includes p-channel transistor 105 and n-channel transistor 103, and the second cross coupled inverter includes p-channel transistor 156 and n-channel transistor 104. P-channel transistor 105 has a channel width-to-length (W/L) ratio of 1X, and p-channel transistor 156 has a channel width-to-length (W/L) ratio of 2X that is two times 1X. Because the second cross coupled inverter includes a p-channel transistor 156 that is twice the size of the p-channel transistor 105 is the first cross coupled inverter, the memory circuit 150 is asymmetrical.

The larger size p-channel transistor 156 causes the second cross coupled inverter to provide additional drive current when transistor 156 is on to store a first logic state in the memory circuit 150 compared to the drive current provided by p-channel transistor 105 when transistor 105 is on to store a second logic state in the memory circuit. Increasing the drive current of the p-channel transistor 156 in the second cross coupled inverter compared to the p-channel transistor 105 in the first cross coupled inverter can help maintain the logic states stored in the memory circuit 150 in the event of an energetic particle strike (i.e., when a logic high state is stored at the drains of transistors 104 and 156). The asymmetrical increase in the sizing and drive current of p-channel transistor 156 compared to transistor 105 provides a significant improvement in overall SER of memory circuit 150 without the need to increase the size of transistor 105. According to other embodiments, the size of the p-channel transistor 156 (e.g., the channel W/L ratio of transistor 156) can be any fractional or integer value that is greater than 1X (such as 1.5X, 2.5X, 3X, 3.5X, 4X, etc.) times the size of transistor 105 to provide additional drive current and a reduced single-event upset (SEU) rate.

In order to store a logic high state in memory circuit 150 at the drains of transistors 103 and 105, the voltage at AL is driven to a logic high state to turn on transistors 101-102, the voltage at bit line node BL is driven to a logic high state, and the voltage at the inverted bit line BLb is driven to a logic low state. In response to logic high states on lines AL and BL and a logic low state on inverted bit line BLb, memory circuit 150 stores a logic high state at the drains of transistors 103 and 105 and a logic low state at the drains of transistors 104 and 156. The addition of transistor 156 to memory circuit 150 may decrease the write margin for writing a logic high state into memory circuit 150 at the drains of transistors 103 and 105, because transistor 156 has an increased drive current relative to the drive current of transistor 102.

The write margin of the memory circuits 100 and 150 can be increased using multiple techniques. According to one exemplary technique, the supply voltage VCC can be temporarily decreased below the voltage of the address line AL and the bit lines BL and BLb during a write operation to the memory circuit 100 or 150 to increase the write margin.

According to another exemplary technique, a tristate p-channel transistor can be added to the memory circuit to turn off the supply current to the extra p-channel transistor 107 during a write operation to the memory circuit to increase the write margin of the memory circuit. Figure 2 is diagram that shows a schematic representation of an asymmetrical memory circuit 200 having an extra tristate p-channel transistor that turns off supply current to the extra p-channel transistor 107 during a write operation. Memory circuit 200 of FIG. 2 includes 4 n-channel FETs 101-104 and 4 p-channel FETs 105-107 and 208. Memory circuit 200 includes the two cross coupled inverters and the two pass transistors 101-102 disclosed herein with respect to FIG. 1A. Memory circuit 200 also includes a tristate p-channel transistor 208 that is coupled between the source of p-channel transistor 107 and the supply line that supplies the supply voltage VCC. The gate of transistor 208 is coupled to receive a Write signal.

During a write operation to write a logic high state in memory circuit 200 at the drains of transistors 103 and 105, the voltage at AL is driven to a logic high state to turn on transistors 101-102, the voltage at bit line node BL is driven to a logic high state, and the Write signal at the gate of transistor 208 is driven to a logic high state. Transistor 208 turns off in response to the logic high state in the Write signal, blocking current from supply voltage VCC to transistor 107 during the write operation. Because transistors 208 and 107 do not supply current to the gates of transistors 103 and 105 during the write operation, the Write signal and transistor 208 decrease the time to write a logic high state at the drains of transistors 103 and 105 during the write operation, and thus increase the write margin for the write operation.

After the write operation is completed, the Write signal is driven to a logic low state, causing transistor 208 to turn on. Current can then flow from supply voltage VCC through transistors 208 and 107 to the gates of transistors 103 and 105 when transistors 106-107 are on in order to maintain a logic high state stored in the memory circuit 200 at the drains of transistors 104 and 106-107 in the event of an energetic particle strike, as discussed above, to reduce the SER.

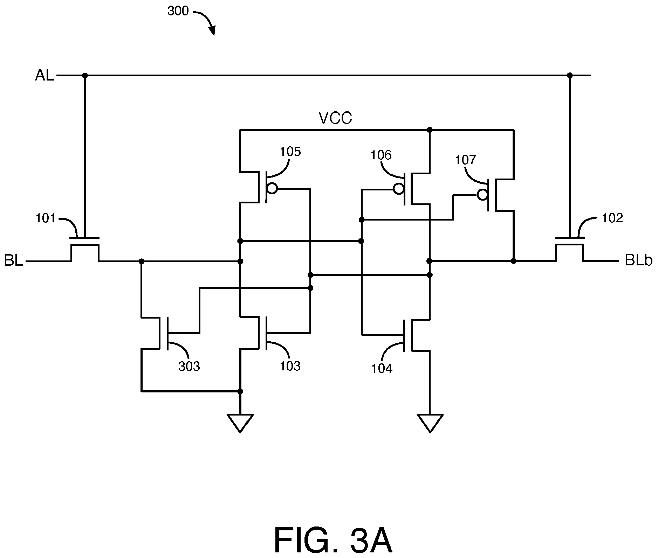

Figure 3A is a diagram that shows a schematic representation of an asymmetrical memory circuit 300 having an additional p-channel transistor in one cross coupled inverter and an additional n-channel transistor in another cross coupled inverter. Memory circuit 300 of Figure 3A includes 5 n-channel FETs 101-104 and 303. Memory circuit 300 also includes 3 p-channel FETs 105-107. Memory circuit 300 includes two cross coupled inverters and two pass transistors 101-102. The cross coupled inverters are coupled between a supply voltage VCC at a first supply line and a ground voltage at a second supply line. The first cross coupled inverter includes p-channel transistor 105 and n-channel transistors 103 and 303. N-channel transistors 103 and 303 are coupled in parallel between the drain of transistors 105 and the second supply line. The second cross coupled inverter includes p-channel transistors 106-107 and n-channel transistor 104. Because the second cross coupled inverter includes two p-channel transistors 106-107 and only one n-channel transistor 104, the first cross coupled inverter includes only one p-channel transistor 105 and two n-channel transistors 103 and 303, the memory circuit 300 is asymmetrical. Transistors 103 and 303 combined are twice the size of transistor 104.

The additional n-channel transistor 303 coupled in parallel with n-channel transistor 103 causes the first cross coupled inverter to provide additional drive current when transistors 103 and 303 are on to store a first logic state in memory circuit 300 compared to the drive current provided by n-channel transistor 104 in the second cross coupled inverter when transistor 104 is on to store a second logic state in memory circuit 300. Increasing the drive current and the combined size of the n-channel transistors 103 and 303 in the first cross coupled inverter compared to the n-channel transistor 104 in the second cross coupled inverter can help maintain the logic states stored in the memory circuit 300 in the event of an energetic particle strike (i.e., when a logic low state is stored at the drains of transistors 103, 105, and 303). The asymmetrical increase in the combined sizing and drive current of n-channel transistors 103 and 303 compared to transistor 104 provides a significant improvement in overall SEU rate without the need to increase the size of transistor 104.

According to other embodiments, memory circuit 300 can include a third n-channel transistor (and also optionally fourth, fifth, etc. n-channel transistors) coupled in parallel with transistors 103 and 303 to provide additional drive current and a reduced SEU rate. According to still other embodiments, the size of the n-channel transistor 103 (e.g., the channel W/L ratio of transistor 103) can be any fractional or integer value that is greater than 1X (such as 1.5X, 2.5X, 3X, 3.5X, 4X, etc.) times the size of transistor 104 to provide additional drive current and a reduced SEU rate, with or without transistor 303.

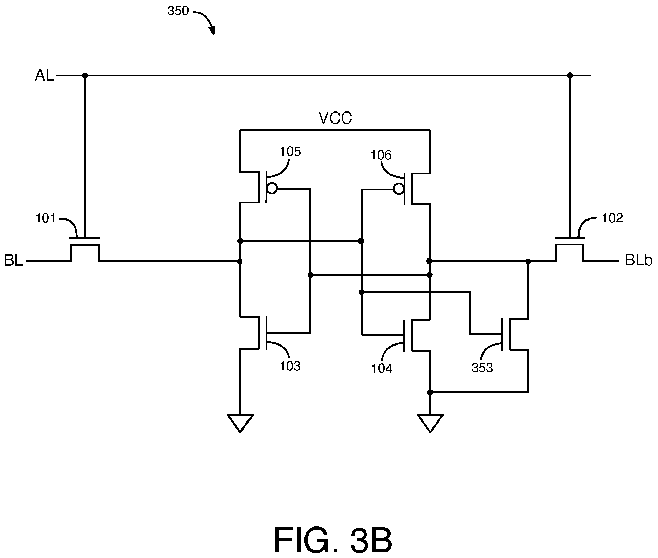

The embodiments disclosed herein add extra p-channel transistor drive current to the storage node in a memory circuit coupled to the inverted bit line BLb. Some of the embodiments disclosed herein (e.g., FIG. 3) also add extra n-channel transistor drive current to the storage node coupled to the bit line BL. The added p-channel drive current best protects against high-to-low SEU transitions for the connecting storage node, while the added n-channel drive current best protects against low-to-high SEU transitions for the connecting storage nodes. Accordingly, an alternative embodiment that specifically targets improved protection only against low-to-high transitions of the storage node coupled to BL can include transistors 103, 104, 105, 106, and 303 coupled as shown in FIG. 3A, and exclude transistor 107.

Figure 3B is a diagram that shows a schematic representation of an asymmetrical memory circuit 350 having an additional n-channel transistor in a cross coupled inverter. Memory circuit 350 of Figure 3B includes 5 n-channel FETs 101-104 and 353 and 2 p-channel FETs 105-106. Memory circuit 350 includes two cross coupled inverters and two pass transistors 101-102. The cross coupled inverters are coupled between a supply voltage VCC at a first supply line and a ground voltage at a second supply line. The first cross coupled inverter includes p-channel transistor 105 and n-channel transistor 103. The second cross coupled inverter includes p-channel transistor 106 and n-channel transistors 104 and 353. N-channel transistors 104 and 353 are coupled in parallel between the drain of transistor 106 and the second supply line. Because the second cross coupled inverter includes two n-channel transistors 104 and 353 and only one p-channel transistor 106, the memory circuit 350 is asymmetrical. Also, transistors 104 and 353 combined are twice the size of transistor 103.

The additional n-channel transistor 353 causes the second cross coupled inverter to provide additional drive current when transistors 104 and 353 are on to store a first logic state in memory circuit 350 compared to the drive current provided by n-channel transistor 103 in the first cross coupled inverter when transistor 103 is on to store a second logic state in memory circuit 350. Increasing the drive current and the combined size of the n-channel transistors 104 and 353 in the second cross coupled inverter compared to the n-channel transistor 103 in the first cross coupled inverter can help maintain the logic states stored in the memory circuit 350 in the event of an energetic particle strike. The asymmetrical increase in the combined sizing and drive current of n-channel transistors 104 and 353 compared to transistor 103 can provide a significant improvement in overall SEU rate without the need to increase the size of transistor 103.

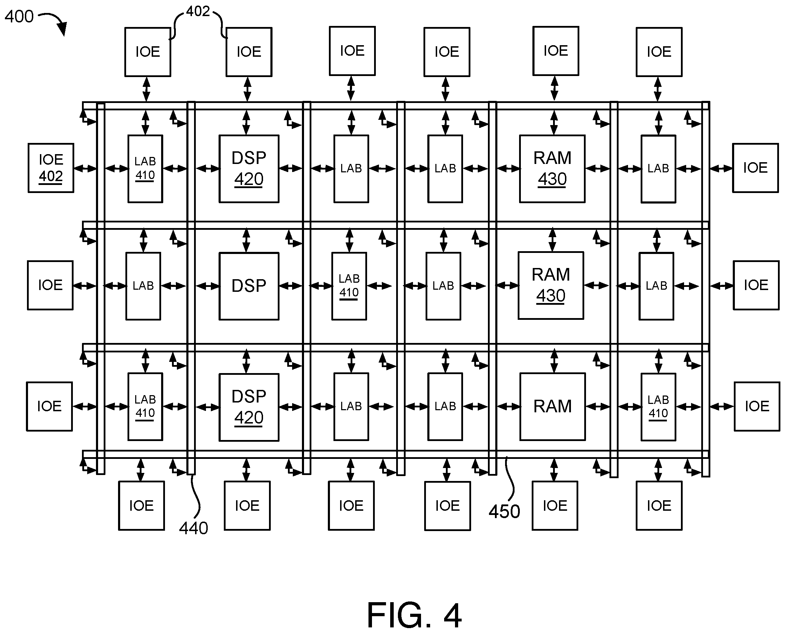

Figure 4 is a diagram of an illustrative example of a configurable integrated circuit (IC) 400. Configurable IC 400 is an example of an IC that can include any of the memory circuits disclosed herein. As shown in FIG. 4, the configurable integrated circuit 400 may include a two-dimensional array of functional blocks, including logic array blocks (LABs) 410 and other functional blocks, such as random access memory (RAM) blocks 430 and digital signal processing (DSP) blocks 420, for example. Functional blocks, such as LABs 410, may include smaller programmable regions (e.g., logic elements, configurable logic blocks, or adaptive logic modules) that receive input signals and perform custom functions on the input signals to produce output signals. RAM blocks 430 can include one or more of the memory circuits disclosed herein, for example, with respect to FIGS. 1A, 1B, 2, and 3A-3B.

In addition, the configurable integrated circuit 400 may have input/output elements (IOEs) 402 for driving signals off of configurable integrated circuit 400 and for receiving signals from other devices. Input/output elements 402 may include parallel input/output circuitry, serial data transceiver circuitry, differential receiver and transmitter circuitry, or other circuitry used to connect one integrated circuit to another integrated circuit. As shown, input/output elements 402 may be located around the periphery of the IC. If desired, the configurable integrated circuit 400 may have input/output elements 402 arranged in different ways. For example, input/output elements 402 may form one or more columns of input/output elements that may be located anywhere on the configurable integrated circuit 400 (e.g., distributed evenly across the width of the configurable integrated circuit). If desired, input/output elements 402 may form one or more rows of input/output elements (e.g., distributed across the height of the configurable integrated circuit). Alternatively, input/output elements 402 may form islands of input/output elements that may be distributed over the surface of the configurable integrated circuit 400 or clustered in selected areas.

The configurable integrated circuit 400 may also include programmable interconnect circuitry in the form of vertical routing channels 440 (i.e., interconnects formed along a vertical axis of configurable integrated circuit 400) and horizontal routing channels 450 (i.e., interconnects formed along a horizontal axis of configurable integrated circuit 400), each routing channel including at least one track to route at least one wire.

Note that other routing topologies, besides the topology of the interconnect circuitry depicted in FIG. 4, may be used. For example, the routing topology may include wires that travel diagonally or that travel horizontally and vertically along different parts of their extent as well as wires that are perpendicular to the device plane in the case of three dimensional integrated circuits, and the driver of a wire may be located at a different point than one end of a wire. The routing topology may include global wires that span substantially all of configurable integrated circuit 400, fractional global wires such as wires that span part of configurable integrated circuit 400, staggered wires of a particular length, smaller local wires, or any other suitable interconnection resource arrangement.

Furthermore, it should be understood that examples disclosed herein may be implemented in any type of integrated circuit. If desired, the functional blocks of such an integrated circuit may be arranged in more levels or layers in which multiple functional blocks are interconnected to form still larger blocks. Other device arrangements may use functional blocks that are not arranged in rows and columns.

Configurable integrated circuit 400 may contain programmable memory elements (e.g., any of the memory circuits of FIGS. 1A, 1B, 2, and/or 3A-3B disclosed herein). Memory elements may be loaded with configuration data (also called programming data) using input/output elements (IOEs) 402. Once loaded, the memory elements each provide a corresponding static control signal that controls the operation of an associated functional block (e.g., LABs 410, DSP 420, RAM 430, or input/output elements 402).

In a typical scenario, the outputs of the loaded memory elements are applied to the gates of field-effect transistors in a functional block to turn certain transistors on or off and thereby configure the logic in the functional block including the routing paths. Programmable logic circuit elements that may be controlled in this way include parts of multiplexers (e.g., multiplexers used for forming routing paths in interconnect circuits), look-up tables, logic arrays, AND, OR, NAND, and NOR logic gates, pass gates, etc.

The memory elements may use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data during programming, the memory elements are sometimes referred to as configuration memory or programmable memory elements.

The programmable memory elements may be organized in a configuration memory array consisting of rows and columns. A data register that spans across all columns and an address register that spans across all rows may receive configuration data. The configuration data may be shifted onto the data register. When the appropriate address register is asserted, the data register writes the configuration data to the configuration memory elements of the row that was designated by the address register.

Configurable integrated circuit 400 may include configuration memory that is organized in sectors, whereby a sector may include the configuration RAM bits that specify the function and/or interconnections of the subcomponents and wires in or crossing that sector. Each sector may include separate data and address registers.

The configurable IC of FIG. 4 is merely one example of an IC that can be used with embodiments disclosed herein. The embodiments disclosed herein can be used with any suitable integrated circuit or system. For example, the embodiments disclosed herein can be used with numerous types of devices such as processor integrated circuits, central processing units, memory integrated circuits, graphics processing unit integrated circuits, application specific standard products (ASSPs), application specific integrated circuits (ASICs), and configurable logic integrated circuits. Examples of configurable logic integrated circuits include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The integrated circuits disclosed in one or more embodiments herein can be part of a data processing system that includes one or more of the following components: a processor; memory; input/output circuitry; and peripheral devices. The data processing system can be used in a wide variety of applications, such as computer networking, data networking, instrumentation, video processing, digital signal processing, or any suitable other application. The integrated circuits can be used to perform a variety of different logic functions.

In general, software and data for performing any of the functions disclosed herein may be stored in non-transitory computer readable storage media. Non-transitory computer readable storage media is tangible computer readable storage media that stores data for access at a later time, as opposed to media that only transmits propagating electrical signals (e.g., wires). The software code may sometimes be referred to as software, data, program instructions, instructions, or code. The non-transitory computer readable storage media may, for example, include computer memory chips, non-volatile memory such as non-volatile random-access memory (NVRAM), one or more hard drives (e.g., magnetic drives or solid state drives), one or more removable flash drives or other removable media, compact discs (CDs), digital versatile discs (DVDs), Blu-ray discs (BDs), other optical media, and floppy diskettes, tapes, or any other suitable memory or storage device(s).

Additional examples are now described. Example 1 is a memory circuit comprising first and second inverters that are cross coupled, wherein the first inverter is configured to provide a first drive current from a first supply line to store a first logic state in the memory circuit, and wherein the first drive current is larger than a second drive current that the second inverter is configured to provide from the first supply line to store a second logic state in the memory circuit.

In Example 2, the memory circuit of Example 1 may optionally include, wherein the first inverter comprises first and second transistors coupled in parallel between the first supply line and an input of the second inverter.

In Example 3, the memory circuit of Example 2 may optionally include, wherein the first inverter further comprises a third transistor coupled between the second transistor and the first supply line.

In Example 4, the memory circuit of Example 1 may optionally include, wherein the first inverter comprises a first transistor coupled to the first supply line, wherein the second inverter comprises a second transistor coupled to the first supply line, and wherein the first transistor has a larger size than the second transistor.

In Example 5, the memory circuit of Example 4 may optionally include, wherein the first transistor has at least two times a channel width-to-length ratio of the second transistor.

In Example 6, the memory circuit of any one of Examples 1-5 may optionally include, wherein the second inverter is configured to provide a third drive current to a second supply line to store the first logic state in the memory circuit, and wherein the third drive current is larger than a fourth drive current that the first inverter is configured to provide to the second supply line to store the second logic state in the memory circuit.

In Example 7, the memory circuit of any one of Examples 1-6 may optionally include, wherein the first drive current is at least two times the second drive current.

In Example 8, the memory circuit of any one of Examples 1-7 may optionally include, wherein the memory circuit is a static random access memory circuit.

In Example 9, the memory circuit of any one of Examples 1-8 further comprises: a first pass transistor coupled between a first bit line and the first and the second inverters; and a second pass transistor coupled between a second bit line and the first and the second inverters.

Example 10 is a method for storing data in a memory circuit, the method comprising: providing a first drive current through a first inverter from a first supply line to store a first logic state in the memory circuit; and providing a second drive current through a second inverter from the first supply line to store a second logic state in the memory circuit, wherein the first drive current is larger than the second drive current.

In Example 11, the method of Example 10 may optionally include, wherein providing the first drive current through the first inverter comprises providing a first portion of the first drive current through a first transistor in the first inverter, and providing a second portion of the first drive current through a second transistor in the first inverter.

In Example 12, the method of Example 11 may optionally include, wherein providing the second portion of the first drive current through the second transistor comprises providing the second portion of the first drive current through the second transistor and a third transistor coupled in series with the second transistor.

In Example 13, the method of Example 10 may optionally include, wherein providing the first drive current through the first inverter comprises providing the first drive current through a first transistor in the first inverter, wherein providing the second drive current through the second inverter comprises providing the second drive current through a second transistor in the second inverter, and wherein the first transistor is larger than the second transistor.

In Example 14, the method of any one of Examples 10-13 further comprises: providing a third drive current through the second inverter to a second supply line to store the first logic state in the memory circuit; and providing a fourth drive current through the first inverter to the second supply line to store the second logic state in the memory circuit, wherein the third drive current is larger than the fourth drive current.

In Example 15, the method of any one of Examples 10-14 may optionally include, wherein the first drive current is at least 1.5 times the second drive current.

Example 16 is a storage circuit comprising: first and second inverters, wherein the first inverter comprises one or more first transistors coupled between a first supply line and a first node in the storage circuit, wherein the second inverter comprises a second transistor coupled between the first supply line and a second node in the storage circuit, and wherein the one or more first transistors have a larger size than the second transistor.

In Example 17, the storage circuit of Example 16 may optionally include, wherein the one or more first transistors comprise at least two of the first transistors coupled in parallel.

In Example 18, the storage circuit of any one of Examples 16-17 may optionally include, wherein the first inverter further comprises a third transistor coupled between a second supply line and the first node, wherein the second inverter further comprises one or more fourth transistors coupled between the second supply line and the second node, and wherein the one or more fourth transistors have a larger area than the third transistor.

In Example 19, the storage circuit of any one of Examples 16-18 may optionally include, wherein a single one of the one or more first transistors has a larger size than the second transistor.

In Example 20, the storage circuit of any one of Examples 16-19 may optionally include, wherein the first and the second inverters are cross coupled.

The foregoing description of the examples has been presented for the purpose of illustration. The foregoing description is not intended to be exhaustive or to be limiting to the examples disclosed herein. In some instances, features of the examples can be employed without a corresponding use of other features as set forth. Many modifications, substitutions, and variations are possible in light of the above teachings.

## Claims

1. A memory circuit comprising:
first and second inverters that are cross coupled, wherein the first inverter is configured to provide a first drive current from a first supply line to store a first logic state in the memory circuit, and wherein the first drive current is larger than a second drive current that the second inverter is configured to provide from the first supply line to store a second logic state in the memory circuit.

2. The memory circuit of claim 1, wherein the first inverter comprises first and second transistors coupled in parallel between the first supply line and an input of the second inverter.

3. The memory circuit of claim 2, wherein the first inverter further comprises a third transistor coupled between the second transistor and the first supply line.

4. The memory circuit of claim 1, wherein the first inverter comprises a first transistor coupled to the first supply line, wherein the second inverter comprises a second transistor coupled to the first supply line, and wherein the first transistor has a larger size than the second transistor.

5. The memory circuit of claim 4, wherein the first transistor has at least two times a channel width-to-length ratio of the second transistor.

6. The memory circuit of any one of claims 1-5, wherein the second inverter is configured to provide a third drive current to a second supply line to store the first logic state in the memory circuit, and wherein the third drive current is larger than a fourth drive current that the first inverter is configured to provide to the second supply line to store the second logic state in the memory circuit.

7. The memory circuit of any one of claims 1-6, wherein the first drive current is at least two times the second drive current.

8. The memory circuit of any one of claims 1-7, wherein the memory circuit is a static random access memory circuit.

9. The memory circuit of any one of claims 1-8 further comprising:
a first pass transistor coupled between a first bit line and the first and the second inverters; and
a second pass transistor coupled between a second bit line and the first and the second inverters.

10. A method for storing data in a memory circuit, the method comprising:
providing a first drive current through a first inverter from a first supply line to store a first logic state in the memory circuit; and
providing a second drive current through a second inverter from the first supply line to store a second logic state in the memory circuit, wherein the first drive current is larger than the second drive current.

11. The method of claim 10, wherein providing the first drive current through the first inverter comprises providing a first portion of the first drive current through a first transistor in the first inverter, and providing a second portion of the first drive current through a second transistor in the first inverter.

12. The method of claim 11, wherein providing the second portion of the first drive current through the second transistor comprises providing the second portion of the first drive current through the second transistor and a third transistor coupled in series with the second transistor.

13. The method of claim 10, wherein providing the first drive current through the first inverter comprises providing the first drive current through a first transistor in the first inverter, wherein providing the second drive current through the second inverter comprises providing the second drive current through a second transistor in the second inverter, and wherein the first transistor is larger than the second transistor.

14. The method of any one of claims 10-13 further comprising:
providing a third drive current through the second inverter to a second supply line to store the first logic state in the memory circuit; and
providing a fourth drive current through the first inverter to the second supply line to store the second logic state in the memory circuit, wherein the third drive current is larger than the fourth drive current.

15. The method of any one of claims 10-14, wherein the first drive current is at least 1.5 times the second drive current.
